# EUROPÄISCHE PATENTSCHRIFT

(11) **EP 0 825 160 B1**
(45) Veröffentlichungstag und Bekanntmachung des Hinweises auf die Patenterteilung: **05.12.2001**
(21) Anmeldenummer: 97113738.5
(22) Anmeldetag: 08.08.1997
(51) Int. Cl.: C04B 35/46, G11C 11/22

(54) **Selbstpolung bei Perowskiten vom Typ ABO 3**
Selfpolarization of ABO3 type perovskites
Autopolarisation de perovskite de type ABO3

(30) Priorität: 17.08.1996 DE 19633175
(43) Veröffentlichungstag der Anmeldung: 25.02.1998
(73) Patentinhaber: FORSCHUNGSZENTRUM JÜLICH GMBH, 52425 Jülich (DE)
(72) Erfinder: Szot, Krzysztof, Dr., 40-086 Katowice (PL); Speier, Wolfgang, Dr., 52428 Jülich (DE)

(56) Entgegenhaltungen:
- EP-A- 0 600 303
- SZOT K ; PAWELCZYK M ; HERION J ; FREIBURG C ; ALBERS J ; WASER R ; HULLIGER J ; KWAPULINSKI J ; DEC J: "Nature of the surface layer in ABO/sub 3/-type perovskites at elevated temperatures " APPLIED PHYSICS A, Bd. 62, April 1996, Seiten 335-343, XP002043869
- SZOT K ; SPEIER W ; HERION J ; FREIBURG C: "Restructuring of the surface region in SrTiO3" APPLIED PHYSICS A, MATER. SCI. PROCESS, Januar 1997, GERMANY, Seiten 55-59, XP002043870

## Beschreibung

Die Erfindung bezieht sich auf ferroelektrische Perowskite vom Typ ABO₃.

Perowskite vom Typ ABO₃ sind z. B. der Druckschrift Appl. Physics A, Vol. 62 (April 1996), S. 335-343" zu entnehmen. Hieraus ist bekannt, daß AO-Komplexe durch eine geeignete thermische Behandlung aus tiefer gelegenen Bereichen des Perowskiten in Richtung seiner Oberfläche verlagert werden können. Die Verlagerung führt zu AO•(ABO₃)ₙ-Komponenten in einem Schichtbereich der Oberfläche. Es können dann BO₂-reiche Phasen in tiefer gelegenen Schichten oder im Körper (unterhalb der Oberflächenschicht) auftreten.

Der Druckschrift Appl. Physics A, Vol. 62 (April 1996), S. 335-343" ist ferner zu entnehmen, daß ein konstanter Stromfluß durch den Perowskiten eine entsprechende Wanderung von Sauerstoffionen innerhalb des Perowskiten zur Folge hat.

Der Druckschrift WO 96/13865 ist eine pin-Schichtenfolge zu entnehmen, die auf Glas aufgebracht ist. Derartige Schichtenfolgen sind für elektronische Bauelemente von Interesse.

Es ist ferner bekannt (allgemeines Fachwissen), daß ferroelektrische Kristalle durch Anlegen eines äußeren elektrischen Feldes polarisiert werden können.

Aufgabe der Erfindung ist die Herstellung von Perowskiten der eingangs genannten Art mit inneren elektrischen Feldern im Oberflächenbereich, die eine makroskopische Orientierung aufweisen, wobei diese Felder mit der makroskopischen Orientierung beim Phasenübergang von der ferroelektrischen zur paraelektrischen Phase nicht verschwinden.

Die Aufgabe wird gelöst, indem ein Perowskit einer oxidierenden Atmosphäre ausgesetzt wird und zwar solange, bis die akkumulierte Menge der Ladung bei der Selbstpolung bei Übergang von paraelektrischer zu ferroelektrischer Phase reproduzierbar gleich der depolarisierten Ladung bei Übergang ferroelektrischer zu paraelektrischer Phase ist.

Ausreichende Gleichheit der Ladungen sowie ausreichende Reproduzierbarkeit liegen vor, wenn die gemessenen Ladungen um ±20% um einen Mittelwert herum schwanken.

Der Perowskit wird einer oxidierenden Atmosphäre ausgesetzt, indem er unter Sauerstoffpartialdruck erhitzt wird. Der Sauerstoffpartialdruck ist dabei so gewählt, daß er größer ist als der Sauerstoffpartialdruck für das Minimum der Defektkonzentration bei der Behandlungstemperatur. Unter Behandlungstemperatur wird die Temperatur verstanden, der der Perowskit während des Herstellungsverfahrens ausgesetzt wird. Behandlungstemperaturen oberhalb von 500 °C haben sich als vorteilhaft herausgestellt.

Das Verfahren ist auf ferroelektrische ABO₃-Perowskite anwendbar.

Die akkumulierte Ladung bei Selbstpolung beim Übergang paraelektrischer zu ferroelektrischer Phase wird wie folgt ermittelt:

An sich gegenüberliegenden Seiten des Perowskiten werden Elektroden angebracht. Diese Elektroden werden miteinander elektrisch kurzgeschlossen. Im kurzgeschlossenen Kreis wird ein Stromeßgerät eingebaut. Der Perowskit wird dann derart abgekühlt, daß die Geschwindigkeit der Abkühlung konstant ist.

Beim Übergang von paraelektrischer zu ferroelektrischer Phase tritt ein Pyrostrom auf. Dieser Pyrostrom wird gemessen und als Zeitfunktion integriert. Das Ergebnis des Integrals ist Maß für die akkumulierte Ladung bei Selbstpolung.

Wird mit konstanter Geschwindigkeit wieder aufgeheizt, so läßt sich auf gleiche Weise die depolarisierte Ladung messen.

Der Vorgang zur Bestimmung der akkumulierten und depolarisierten Ladung wird mehrfach wiederholt. Auf diese Weise wird festgestellt, daß die beiden Ladungen reproduzierbar gleich groß sind.

Durch das Erhitzen des Perowskiten in oxidierender Atmosphäre entstehen pin-Schichten auf der Oberfläche. Dieser Effekt wird in DE 196 16 730 A1 beschrieben. Anfänglich sind die pin-Schichten derart dünn, daß der Selbstpolungseffekt zu gering ist. Mit zunehmender Dicke der pin-Schichten nimmt der Selbstpolungseffekt zu. Es gibt jedoch ein Maximum. Wird dieses überschritten, nimmt der Selbstpolungseffekt wieder ab. Eine geeignete pin-Schichtdicke liegt vor, wenn akkumulierte und depolarisierte Ladung reproduzierbar gleich sind.

Daß der Selbstpolungseffekt wieder abnimmt, beruht auf sich bildenden diffusen Übergängen zwischen p, i oder n-Schicht. Mit zunehmender Dicke werden die Übergänge diffuser, so daß es eine maximale pin-Schichtdicke gibt, die nicht überschritten werden darf, wenn der Selbstpolungseffekt eintreten soll.

Der Pyrostrom läßt sich nach vorgenannter Art nur dann messen, wenn die Selbstpolung auf einer Seite des Perowskiten nicht durch die Selbstpolung der gegenüberliegenden Seite des Perowskiten kompensiert wird, weil die Spontanen Polarisationsvektoren auf den beiden Seiten antiparallel sind. Zur Vermeidung eines solchen Aufhebungseffektes wird der Perowskit entweder aufgeschnitten oder es wird verhindert, daß auf einer der beiden Seiten eine entsprechende pin-Struktur mit Selbstpolung sich ausbildet. Die pin-Schichtbildung kann verhindert werden, indem eine Seite bei der Herstellung einem geeigneten Sauerstoffpartialdruck ausgesetzt wird. Ein geeigneter Sauerstoffpartialdruck liegt insbesondere vor, wenn dieser dem Sauerstoffpartialdruck des Minimums der Defektkonzentration für die Temperatur entspricht.

Die optimalen Parameter, also der Sauerstoffpartialdruck, die Temperatur und die Behandlungszeit zur Erzielung des Selbstpolungseffektes müssen nur einmal ermittelt werden. Anschließend kann jeder Perowskit gleicher Bauart in gleicher Weise behandelt werden, um einen Selbstpolungseffekt zu bewirken. Die anschließende Messung der depolarisierten und akkumulierten Ladung ist dann also nicht mehr erforderlich.

Im folgenden wird die Erfindung anhand eines Ausführungsbeispiels dargestellt.

Ein Bariumtitanat-Einkristall wurde eine Stunde lang bei einem Sauerstoffpartialdruck von 263 mbar (200 Torr) auf 1000 °C erhitzt. Die anschließende Messung der depolarisierten bzw. akkumulierten Ladung ergab einen Wert von 25 µCoulomb pro cm². Als ausreichend hat sich herausgestellt, wenn reproduzierbar ein Wert von 20 µCoulomb ± 20 % erreicht worden ist. Nach der Präparation wurde der Kristall in mehrere Stücke geteilt, so daß die Stücke auf der einen Seite eine wie oben beschriebene Oberflächenregion mit pin-Struktur aufwiesen, die nicht um den ganzen Kristall herumreichten.

## Patentansprüche

1. Verfahren zur Herstellung eines ferroelektrischen Perowskiten vom Typ ABO₃ mit permanenten inneren elektrischen Feldern im Oberflächenbereich, die eine makroskopische Orientierung aufweisen, indem der Perowskit solange einer oxidierenden Atmosphäre ausgesetzt wird, bis die akkumulierte Ladung bei Übergang von paraelektrischer zu ferroelektrischer Phase reproduzierbar, d. h. im Bereich ± 20 % um einen Mittelwert, gleich der depolarisierten Ladung bei Übergang ferroelektrischer zu paraelektrischer Phase ist.

## Claims

1. Method for the manufacture of a ferroelectric perovskite of the ABO₃ type with permanent inner electrical fields in the surface region that have a macroscopic orientation, by exposing the perovskite to an oxidizing atmosphere until the accumulated charge upon transition from paraelectric to ferroelectric phase is reproduceably, that is to say within the range of ± 20% about an average value, equal to the depolarized charge upon transition from ferroelectric to paraelectric phase.

## Revendications

1. Procédé pour produire d'une pérovskite ferroélectrique du type ABO₃ avec des champs électriques internes permanents présents dans la zone superficielle, qui possèdent une orientation macroscopique, par le fait qu'on soumet la pérovskite à une atmosphère oxydante jusqu'à ce que la charge cumulée lors du passage de la phase paraélectrique à la phase ferroélectrique soit reproductible, c'est-à-dire dans la gamme de + 20 % autour d'une valeur moyenne égale à la charge dépolarisée lors du passage de la phase ferroélectrique à la phase paraélectrique.
